(19) Europäisches Patentamt
European Patent Office
Office européen des brevets

(11) EP 3 426 008 B1

(12) EUROPEAN PATENT SPECIFICATION

(45) Date of publication and mention of the grant of the patent:
**25.03.2020 Bulletin 2020/13**

(21) Application number: **18183747.7**

(22) Date of filing: **25.10.2013**

(51) Int Cl.:
***H05B 33/28*** *(2006.01)* ***H01L 51/52*** *(2006.01)*
***H01B 1/12*** *(2006.01)* ***H01L 51/44*** *(2006.01)*
***H01L 51/56*** *(2006.01)* ***H01L 51/00*** *(2006.01)*
***H05K 1/09*** *(2006.01)* ***H05K 3/10*** *(2006.01)*

(54) **TRANSPARENT LAYERS OF HIGH CONDUCTIVITY AND HIGH EFFICIENCY IN OLEDS AND PROCESS FOR THEIR PRODUCTION**

TRANSPARENTE SCHICHTEN MIT HOHER LEITFÄHIGKEIT UND HOHEM WIRKUNGSGRAD IN OLEDS UND VERFAHREN ZU DEREN HERSTELLUNG

COUCHES TRANSPARENTES DE CONDUCTIVITÉ ÉLEVÉE ET UNE EFFICACITÉ ÉLEVÉE DANS DES OLED ET LEUR PROCÉDÉ DE PRODUCTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.10.2012 DE 102012020993**
**16.11.2012 US 201261727366 P**
**05.04.2013 DE 102013005763**
**29.04.2013 US 201361817047 P**

(43) Date of publication of application:
**09.01.2019 Bulletin 2019/02**

(62) Document number(s) of the earlier application(s) in accordance with Art. 76 EPC:
**13786163.9 / 2 912 923**

(73) Proprietor: **Heraeus Deutschland GmbH & Co KG**
**63450 Hanau (DE)**

(72) Inventors:
- **Lövenich, Wilfried**
  **51469 Bergisch Gladbach (DE)**
- **Sautter, Armin**
  **40593 Düsseldorf (DE)**
- **Elschner, Andreas**
  **45468 Mülheim (DE)**
- **Scheel, Arnulf**
  **50735 Köln (DE)**
- **Riesebeck, Detlef**
  **47239 Duisburg (DE)**
- **Kirchmeyer, Stephan**
  **51381 Leverkusen (DE)**

(74) Representative: **Herzog IP Patentanwalts GmbH**
**Immermannstraße 40**
**40210 Düsseldorf (DE)**

(56) References cited:
**EP-A2- 0 991 303** **DE-A1-102004 010 811**
**DE-A1-102007 041 722** **DE-A1-102010 012 180**

EP 3 426 008 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The present invention relates to the use of a dispersion. An electroluminescent arrangement (EL arrangement) is characterized in that when an electrical voltage is applied, it emits light with a flow of current. Such arrangements have been known for a long time by the name "light-emitting diodes" (LEDs). The emission of light arises by positive charges ("holes") and negative charges ("electrons") recombining with the emission of light. The LEDs customary in the art are all made predominantly of inorganic semiconductor materials. However, EL arrangements of which the essential constituents are organic materials have been known for some years (OLEDs = "organic light-emitting diodes"). These organic EL arrangements as a rule comprise one or more layers of organic charge transport compounds.

The main layer structure of an EL arrangement is e.g. as follows:

1 carrier, substrate
2 base electrode
3 hole-injecting layer
4 hole-transporting layer
5 emitter layer
6 electron-transporting layer
7 electron-injecting layer
8 top electrode
9 contacts
10 sheathing, encapsulation

This structure is a detailed case, and can be simplified by omitting individual layers, so that one layer assumes several tasks. In the simplest case, an EL arrangement comprises two electrodes, between which is an organic layer which fulfils all the functions - including the emission of light. However, it has been found in practice that to increase the luminance, electron- and/or hole-injecting layers are particularly advantageous in the electroluminescent structures.

DE-A-10 2004 010 811 discloses employing specific mixture of conductive organic polymeric conductors, such as poly(3,4-ethylenedioxythiophene), polymers comprising $SO_3^-M^+$ groups, such as polystyrenesulphonic acid (PSS), and partially fluorinated or perfluorinated polymers comprising $SO_3^-M^+$ groups, such as, for example, Nafion®, as a hole-injecting layer of an OLED, glass coated with ITO (indium tin oxide) preferably being used as the base electrode in the OLEDS of this prior art.

In addition to the use for the production of hole injection layers in OLEDS, dispersions comprising PEDOT/PSS are often also used for the production of conductive layers in OPV elements ("organic photovoltaic" element; organic solar cells). Thus, PEDOT/PSS dispersions are employed, for example, for the production of the intermediate layer between the ITO-coated substrate and the semiconductor layer in the standard construction of the P3HT : PCBM solar cell or for the production of a layer in a solar cell of inverted construction, such as is described, for example, in chapter 2.1 in the dissertation "Zur Funktionsweise organischer Solarzellen auf der Basis interpenetrierender Donator/Akzeptor-Netzwerke" (2007) by Markus Glatthaar, University of Freiburg. The PEDOT/PSS layer in this context is spun (e.g. by "spin coating") from an aqueous or isopropanol-based dispersion on to a substrate (ITO in the case of a solar cell of standard construction or on to a semiconductor layer, for example a P3HT : PCBM layer , in the case of a solar cell of inverted construction).

However, in the field of the production of OLEDs or of OPV elements efforts are currently being made to dispense with the use of ITO, since in contrast to conductive polymer layers, for example, this is not flexible. The disadvantage of the PEDOT/PSS-comprising dispersions known from the prior art is, however, that the conductivity of these layers is too low for them to be employed not only as a hole injection layer in an OLED or as an intermediate layer between the ITO-coated substrate and the semiconductor layer in the standard construction of a P3HT : PCBM solar cell, but as a simultaneous substitute for the underlying ITO layer (base electrode). So that layers comprising conductive polymers can replace the ITO layers in OLEDs and OPV elements, they must not only have a high conductivity (or a low surface resistance), but also have a high transmission.

The present invention was based on the object of overcoming the disadvantages resulting from the prior art in connection with electronic components, in particular in connection with OLEDs and OPV elements.

The present invention was based on the object of providing electronic components, such as OLEDs and OVP elements, which are characterized by a less complex layered structure compared with the OLEDs and OVP elements known from the prior art.

The present invention was also based on the object of providing a dispersion from which transparent conductive layers which in an OLED or an OPV element serve at the same time as a hole injection layer and as a base electrode and therefore in particular can replace the layer sequence of ITO layer/hole injection layer in conventional OLEDs can be deposited

A contribution towards achieving these objects is made by a process for the production of a transparent electrode comprising the process steps:

I) provision of a transparent substrate layer,

II) application of a grid structure comprising a plurality of bars of metal or at least comprising metallic particles to the substrate layer,

III) application of a dispersion comprising

a) at least one polythiophene,

b) at least one polymer having $SO_3^-M^+$ groups,

c) at least one fluorinated or perfluorinated polymer having $SO_3^-M^+$ groups, and

d) at least one dispersing agent,
wherein $M^+$ represents $H^+$, $Li^+$, $Na^+$, $K^+$ or $NH_4^+$,
to the transparent substrate layer provided with the grid structure, and

IV) at least partial removal of the dispersing agent resulting in obtaining a transparent electrode.

In process step I) of the process according to the invention a transparent substrate layer is first provided. Possible transparent substrates in this context are all layers which can be employed in electronic components, such as, for example, an OLED or an OVP element. In this context glass or transparent films of plastic are possible in particular. Particularly suitable transparent plastics are, for example, polycarbonates, polyesters, such as e.g. PET and PEN (polyethylene terephthalate or polyethylene-naphthalene dicarboxylate), copolycarbonates, polyacrylates, polysulphones, polyether sulphones (PES), polyimides, polyethylene, polypropylene, cyclic polyolefins or cyclic olefin copolymers (COC), hydrogenated styrene polymers or hydrogenated styrene copolymers. Suitable polymer substrates can also be, for example, films, such as polyester films, PES films from Sumitomo or polycarbonate films from Bayer AG (Makrofol®). Transparent substrate layers which are particularly preferred according to the invention are transparent polymer layers, in particular flexible transparent polymer layers having a layer thickness in a range of from 0.1 to 500 μm, particularly preferably having a layer thickness in a range of from 50 to 250 μm.

In process step II) of the process according to the invention, a grid structure comprising a plurality of bars of metal or at least comprising metallic particles is applied to the substrate layer, it being possible for this application to be carried out by vapour deposition of metals using corresponding shadow masks (it being possible for layers of different metals optionally to be applied on top of one another), by printing by means of a paste comprising metallic particles, or by etching a metal layer applied over the complete surface of the substrate layer. Possible metals in this context are all metals which are conventionally employed in electronic components for the production of linear, metallic structures (so-called "busbars"), such as, for example, aluminium, silver, gold, copper or chromium. In the case of bars comprising metallic particles, it is preferable for these to be applied in the form of pastes which comprise such metallic particles having a particle diameter of less than 1 μm. Conductive silver particles or copper particles are very particularly preferred in this connection. If pastes which, in addition to the metallic particles, in particular can comprise solvents and binders are used, it is furthermore preferable for the grid structures to be applied via screen printing processes. In this context the grid structure can comprise adjacent lines, adjacent rectangles, adjacent honeycombs ("honeycomb structure) or any other arrangement having a regular structure.

It is furthermore preferable according to the invention for the width of the bars of the grid structure preferably to be in a range of from 1 to 1,000 μm, still more preferably in a range of from 20 to 200 μm, while the height of the bars of the grid structure is in a range of from 0.1 to 20 μm, still more preferably in a range of from 0.2 to 5 μm. It is furthermore preferable according to the invention for the distance between adjacent bars in the grid structure preferably to be in a range of from 0.5 to 30 mm, still more preferably in a range of from 3 to 10 mm. It has also proved advantageous for between 0.1 and 20 %, particularly preferably between 0.5 and 5 % of the surface of the transparent substrate layer in the transparent electrode according to the invention to be covered by the bars of the grid structure. The conductivity of the bars is preferably at least 1,000 S/cm, still more preferably at least 50,000 S/cm.

In process step III) of the process according to the invention, a dispersion comprising

a) at least one polythiophene,

b) at least one polymer having $SO_3^-M^+$ groups,

c) at least one fluorinated or perfluorinated polymer having $SO_3^-M^+$ groups, and

d) at least one dispersing agent,
wherein $M^+$ represents $H^+$, $Li^+$, $Na^+$, $K^+$ or $NH_4^+$,
is then applied to the transparent substrate layer provided with the grid structure.

The dispersion employed in process step III) comprises as component a) a polythiophene, it being particularly preferable for this polythiophene to be a polythiophene having recurring units of the general formula (i) or (ii) or a combination of units of the general formulae (i) and (ii), very particularly preferably a polythiophene having recurring units of the general formula (ii)

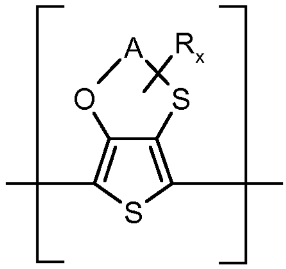

(i)

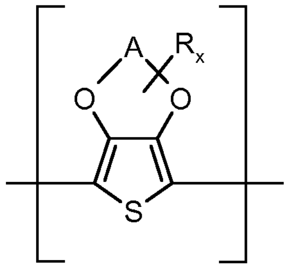

(ii)

wherein

A represents an optionally substituted $C_1$-$C_5$-alkylene radical,

R represents a linear or branched, optionally substituted $C_1$-$C_{18}$-alkyl radical, an optionally substituted $C_5$-$C_{12}$-cycloalkyl radical, an optionally substituted $C_6$-$C_{14}$-aryl radical, an optionally substituted $C_7$-$C_{18}$-aralkyl radical, an optionally substituted $C_1$-$C_4$-hydroxyalkyl radical or a hydroxyl radical,

x represents an integer from 0 to 8 and

in the case where several radicals R are bonded to A, these can be identical or different.
The general formulae (i) and (ii) are to be understood as meaning that x substituents R can be bonded to the alkylene radical A.
Polythiophenes having recurring units of the general formula (ii) wherein A represents an optionally substituted $C_2$-$C_3$-alkylene radical and x represents 0 or 1 are particularly preferred.
In the context of the invention the prefix "poly" is to be understood as meaning that the polymer or polythiophene comprises more than one identical or different recurring units of the general formulae (i) and (ii). In addition to the recurring units of the general formulae (i) and/or (ii), the polythiophenes can optionally also comprise other recurring units, but it is preferable for at least 50 %, particularly preferably at least 75 % and most preferably at least 95 % of all the recurring units of the polythiophene to have the general formula (i) and/or (ii), preferably the general formula (ii). The percentage figures stated above are intended here to express the numerical content of the units of the structural formula (i) and (ii) in the total number of monomer units in the foreign-doped conductive polymer. The polythiophenes comprise a total of n recurring units of the general formula (i) and/or (ii), preferably of the general formula (ii), wherein n is an integer from 2 to 2,000, preferably 2 to 100. The recurring units of the general formula (i) and/or (ii), preferably of the general formula (ii), can in each case be identical or different within a polythiophene. Polythiophenes having in each case identical recurring units of the general formula (ii) are preferred.
According to a very particular embodiment of the process according to the invention, at least 50 %, particularly preferably at least 75 %, still more preferably at least 95 % and most preferably 100 % of all the recurring units of the polythiophene a) are 3,4-ethylenedioxythiophene units (i.e. the most preferred polythiophene according to component a) is poly(3,4-ethylenedioxythiophene)).
The polythiophenes preferably in each case carry H on the end groups.
In the context of the invention $C_1$-$C_5$-alkylene radicals A are preferably methylene, ethylene, n-propylene, n-butylene or n-pentylene. $C_1$-$C_{18}$-Alkyl radicals R preferably represent linear or branched $C_1$-$C_{18}$-alkyl radicals, such as methyl, ethyl, n- or iso-propyl, n-, iso-, sec- or tert-butyl, n-pentyl, 1-methylbutyl, 2-methylbutyl, 3-methylbutyl, 1-ethylpropyl, 1,1-dimethylpropyl, 1,2-dimethylpropyl, 2,2-dimethylpropyl, n-hexyl, n-heptyl, n-octyl, 2-ethylhexyl, n-nonyl, n-decyl, n-undecyl, n-dodecyl, n-tridecyl, n-tetradecyl, n-hexadecyl or n-octadecyl, $C_5$-$C_{12}$-cycloalkyl radicals R represent, for example, cyclopentyl, cyclohexyl, cycloheptyl, cyclooctyl, cyclononyl or cyclodecyl, $C_5$-$C_{14}$-aryl radicals R represent, for example, phenyl or naphthyl, and $C_7$-$C_{18}$-aralkyl radicals R represent, for example, benzyl, o-, m-, p-Tolyl, 2,3-, 2,4-, 2,5-, 2,6-, 3,4-, 3,5-xylyl or mesityl. The preceding list serves to illustrate the invention by way of example and is not to be considered conclusive.

In the context of the invention numerous organic groups are possible as optional further substituents of the radicals A and/or of the radicals R, for example alkyl, cycloalkyl, aryl, aralkyl, alkoxy, halogen, ether, thioether, disulphide, sulphoxide, sulphone, sulphonate, amino, aldehyde, keto, carboxylic acid ester, carboxylic acid, carbonate, carboxylate, cyano, alkylsilane and alkoxysilane groups and carboxamide groups.

The polythiophenes a) are preferably cationic, "cationic" relating only to the charges on the polythiophene main chain. The positive charges are not shown in the formulae, since their precise number and position cannot be determined absolutely. However, the number of positive charges is at least 1 and at most n, where n is the total number of all recurring units (identical or different) within the polythiophene.

To compensate the positive charge, the cationic polythiophenes require anions as counter-ions, it being preferable according to the invention for the polymers having $SO_3^-M^+$ groups (= polyanions) to serve as counter-ions to the polythiophenes. Polyanions b) having $SO_3^-M^+$ groups are preferably polymeric sulphonic acids, such as polystyrenesulphonic acid or polyvinylsulphonic acid. These polysulphonic acids can also be copolymers of vinylcarboxylic and vinylsulphonic acids with other polymerizable monomers, such as acrylic acid esters and styrene. The anion of polystyrenesulphonic acid (PSS) is particularly preferred as the polymer having $SO_3^-M^+$ groups in the sense of component b). The molecular weight of the polymers having $SO_3^-M^+$ groups is preferably 1,000 to 2,000,000, particularly preferably 2,000 to 500,000. The polymers having $SO_3^-M^+$ groups or their alkali metal salts are commercially obtainable or can be prepared by known processes (see e.g. Houben Weyl, Methoden der organischen Chemie, vol. E 20 Makromolekulare Stoffe, part 2, (1987), p. 1141 et seq.).

It is particularly preferable according to the invention for the polythiophenes a) and the polymers b) having $SO_3^-M^+$ groups to be present in the form of ionic complexes of polythiophenes and polyanions in the dispersion employed in process step III), very particularly preferably in the form of ionic complexes of poly(3,4-ethylenedioxythiophene) and polystyrenesulphonic acid (so-called PEDOT/PSS complexes). Such ionic complexes are obtainable by polymerizing 3,4-ethylenedioxythiophene oxidatively in aqueous solution in the presence of polystyrenesulphonic acid. Details of this are to be found, for example, in chapter 9.1.3 in "PEDOT · Principles and Applications of an Intrinsically Conductive Polymer", Elschner et al., CRC Press (2011). Further details of this are also described below in connection with the process for the preparation of the dispersion employed in process step III).

The ionic complexes of polythiophenes a) and polymers b) having $SO_3^-M^+$ groups, in particular the PEDOT/PSS ionic complexes, are preferably present in the form of particles in the dispersion employed in process step III). These particles preferably have a diameter $d_{50}$ in a range of from 1 to 100 nm, particularly preferably in a range of from 1 to 60 nm and still more preferably in a range of from 5 to 40 nm. The $d_{50}$ value of the diameter distribution says in this context that 50 % of the total weight of all the particles in the dispersion can be assigned to those particles which have a diameter of less than or equal to the $d_{50}$ value. The diameter of the particles is determined via an ultracentrifuge measurement. The general procedure is described in Colloid Polym. Sci. 267, 1113-1116 (1989).

The dispersion employed in process step III) furthermore comprises as component c) at least one fluorinated or perfluorinated polymer having $SO_3^-M^+$ groups, a copolymer of a perfluorinated sulphonic acid and tetrafluoroethylene being particularly preferred as component c). In this connection, very particularly preferred copolymers are those comprising recurring units of the formulae (II-a) and (II-b)

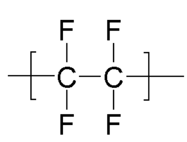

(II-a)

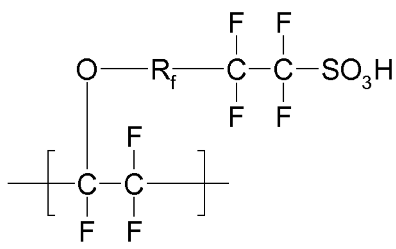

(II-b)

wherein $R_f$ represents a radical having at least one, preferably 1 to 30 recurring unit(s) of the formula (II-c)

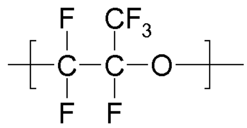

(II-c)

Such perfluorinated polymers are, for example, the polymers commercially obtainable under the trade name Nafion® or in dissolved form under the trade name Liquion®. Suitable fluorinated or perfluorinated polymers having $SO_3^-M^+$ groups are furthermore the polymers obtainable from FuMA-Tech GmbH, Germany, which are obtainable in the form of dispersions under the trade name fumion® 805, fumion® 905 and fumion® 1005.

The dispersion employed in process step III) furthermore comprises as component d) at least one dispersing agent, water, organic solvents or mixtures of organic solvent and water being preferred as the dispersing agent. Dispersing agents which may be mentioned are, for example, the following solvents: aliphatic alcohols, such as methanol, ethanol, i-propanol and butanol; aliphatic ketones, such as acetone and methyl ethyl ketone; aliphatic carboxylic acid esters, such as ethyl acetate and butyl acetate; aromatic hydrocarbons, such as toluene and xylene; aliphatic hydrocarbons, such as hexane, heptane and cyclohexane; chlorohydrocarbons, such as methylene chloride and dichloroethane; aliphatic nitriles, such as acetonitrile; aliphatic sulphoxides and sulphones, such as dimethylsulphoxide and sulpholane; aliphatic carboxylic acid amides, such as methylacetamide, dimethylacetamide and dimethylformamide; aliphatic and araliphatic ethers, such as diethyl ether and anisole. Water or a mixture of water with the abovementioned organic solvents can furthermore also be used as the dispersing agent. Preferred dispersing agents are water or other protic solvents, such as alcohols, e.g. methanol, ethanol, i-propanol and butanol, and mixtures of water with these alcohols. A particularly preferred dispersing agent is water.

The dispersion employed in process step III) can comprise, in addition to the at least one polythiophene a), the at least one polymer b) having $SO_3^-M^+$ groups, the at least one fluorinated or perfluorinated polymer c) having $SO_3^-M^+$ groups and the at least one dispersing agent d), at least one additive, as component e), which differs from components a) to d). Possible additives e) are

- surface-active substances, e.g. anionic surfactants, such as e.g. alkylbenzenesulphonic acids and salts, paraffinsulphonates, alcohol sulphonates, ether sulphonates, sulphosuccinates, phosphate esters, alkyl ether carboxylic acids or carboxylates, cationic surfactants, such as e.g. quaternary alkylammonium salts, nonionic surfactants, such as e.g. linear alcohol ethoxylates, oxo alcohol ethoxylates, alkylphenol ethoxylates or alkyl polyglucosides,

- adhesion promoters, such as e.g. organofunctional silanes or hydrolysates thereof, e.g. 3-glycidoxypropyltrialkoxysilane, 3-aminopropyltriethoxysilane, 3-mercaptopropyltrimethoxysilane, 3-methacryloxypropyltrimethoxysilane, vinyltrimethoxysilane or octyltriethoxysilane, or

- crosslinking agents, such as melamine compounds, masked isocyanates, functional silanes - e.g. tetraethoxysilane, alkoxysilane hydrolysates, e.g. based on tetraethoxysilane, epoxysilanes, such as 3-glycidoxypropyltrialkoxysilane, epoxides or oxetanes,

- binders, such as, for example, polyalkylene glycols, polyacrylates, polyurethanes, polyesters, polyethers, polyamides or polyvinyl alcohol,

- additives which increase the conductivity, such as, for example, polyalkylene glycols, in particular polyethylene glycols or polypropylene glycols, polyglycerols or mixtures of these, polyols, such as propylene glycol and ethylene glycol, sulphoxides, such as dimethylsulphoxide, carboxylic acid amides, such as methylacetamide, dimethylacetamide, dimethylformamide, N-methylpyrrolidone, N-cyclohexylpyrrolidone, ionic liquids, sugars, such as sorbitol,

the use of crosslinking agents as the additive e) being particularly preferred.

According to a preferred embodiment of the dispersion employed in process step III), this comprises, in each case based on the total weight of the dispersion,

a) 0.01 to 1 wt.%, particularly preferably 0.05 to 0.5 wt.% of the at least one polythiophene,

b) 0.01 to 5 wt.%, particularly preferably 0.1 to 3 wt.% of the at least one polymer having $SO_3^-M^+$ groups,

c) 0.01 to 5 wt.%, particularly preferably 0.1 to 3 wt.% of the at least one fluorinated or perfluorinated polymer having $SO_3^-M^+$ groups,

d) 69 to 99.97 wt.%, particularly preferably 83.5 to 98.75 wt.% of the at least one dispersing agent, and

e) 0 to 20 wt.%, particularly preferably 1 to 10 wt.% of the at least one additive which differs from components a) to d).

It is furthermore preferable for the dispersion employed in process step III) to have a pH in a range of from 1 to 7, particularly preferably in a range of from 3 to 7, at a temperature of 25 °C. The viscosity at 20 °C of the dispersions employed in process step III) is preferably less than 1,000 mPas, preferably less than 400 mPas. The dispersions employed in process step III) can furthermore comprise a small amount of ionic impurities in the limits such as are described in EP-A-991 303. Preferably, the dispersions employed in process step III) comprise less than 1,000 ppm of ionic impurities.

The solids content of the dispersions employed in process step III) is preferably in a range of from 0.1 to 10 wt.%, particularly preferably in a range of from 0.5 to 7.5 wt.% and most preferably in a range of from 1 to 5 wt.%.

The dispersions employed in process step III) are preferably characterized by an FOM value (FOM = "figure of merit"), determined in accordance with the test method described herein, of at most 100 Ω/sq, particularly preferably of at most 50 Ω/sq and most preferably of at most 25 Ω/sq.

The dispersion employed in process step III) is preferably prepared by a process comprising the process steps

(α1) provision of a dispersion comprising at least one dispersing agent and complexes of the at least one polythiophene a) and the at least one polymer b) having $SO_3^-M^+$ groups, these complexes being obtained by the oxidative polymerization of thiophene monomers in the presence of the polymer b) having $SO_3^-M^+$ groups, a coating formed from this dispersion having a conductivity of at least 25 S/cm, preferably of at least 50 S/cm;

(α2) mixing of the dispersion obtained in process step (a1) with the at least one fluorinated or perfluorinated polymer c) having $SO_3^-M^+$ groups.

In process step (α1), a dispersion comprising at least one dispersing agent and complexes of the at least one polythiophene a) and the at least one polymer b) having $SO_3^-M^+$ groups is first provided, these complexes being obtained by the oxidative polymerization of thiophene monomers in the presence of the polymer b) having $SO_3^-M^+$ groups.

The polymerization of the thiophene monomers (in the case of poly(3,4-ethylenedioxythiophene) as the polythiophene according to component a) the polymerization of 3,4-ethylenedioxythiophene) is carried out with suitable oxidizing agents in suitable solvents. Examples of suitable oxidizing agents are iron(III) salts, in particular $FeCl_3$ and iron(III) salts of aromatic and aliphatic sulphonic acids, $H_2O_2$, $K_2Cr_2O_7$, $K_2S_2O_8$, $Na_2S_2O_8$, $KMnO_4$, alkali metal perborates and alkali metal or ammonium persulphates or mixtures of these oxidizing agents. Further suitable oxidizing agents are described, for example, in Handbook of Conducting Polymers (ed. Skotheim, T.A.), Marcel Dekker: New York, 1986, vol. 1, 46-57. Particularly preferred oxidizing agents are $FeCl_3$, $Na_2S_2O_8$ and $K_2S_2O_8$ or mixtures of these. The polymerization is preferably carried out at a reaction temperature of from -20 to 100 °C. Reaction temperatures of from 20 to 100 °C are particularly preferred. The polymerization is preferably carried out under an inert gas atmosphere, and the reaction is particularly preferably carried out under reduced pressure (in vacuum). If appropriate, the reaction solution is then treated with at least one ion exchanger.

Suitable solvents for the abovementioned reaction are e.g. polar solvents, for example, water, alcohols, such as methanol, ethanol, 2-propanol, n-propanol, n-butanol, diacetone alcohol, ethylene glycol, glycerol or mixtures of these. Aliphatic ketones, such as acetone and methyl ethyl ketone, aliphatic nitriles, such as acetonitrile, aliphatic and cyclic amides, such as N,N-dimethylacetamide, N,N-dimethylformamide (DMF) and 1-methyl-2-pyrrolidone (NMP), ethers, such as tetrahydrofuran (THF), and sulphoxides, such as dimethylsulphoxide (DMSO), or mixtures of these with one another or with the abovementioned solvents are likewise suitable.

It is particularly preferable according to the invention for the oxidizing agent only to be added to the thiophene monomer dissolved or dispersed in the solvent when the reaction medium has been rendered inert with the aid of an inert gas. In the context of the present invention the reaction medium is regarded as rendered inert here when the inert gas has been passed through the reaction medium for at least 5 minutes, preferably at least 20 minutes. Argon, helium or nitrogen, for example, are suitable as the inert gas. The reaction medium is also regarded as being rendered inert when the internal pressure of the reaction vessel has been lowered at least once and the internal pressure has then been increased by addition of inert gas. It is furthermore preferable according to the invention for the polymerization to be carried out under a pressure which is below the atmospheric pressure as is described in DE-A-10 2007 041 722. By the process measures described above, dispersions comprising complexes of the at least one polythiophene a) and the at least one polymer b) having $SO_3^-M^+$ groups which are characterized by a particularly high conductivity can be prepared.

After the preparation of the dispersion comprising components a) and b) in process step ($\alpha$1), this is then mixed in process step ($\alpha$2) with the at least one fluorinated or perfluorinated polymer c) having $SO_3^-M^+$ groups, it being possible for this mixing to be carried out, for example, by a high pressure homogenization, which can optionally also be carried out several times. Preferably, in this context the fluorinated or perfluorinated polymer c) having $SO_3^-M^+$ groups is mixed in the form of a dispersion, for example in the form of the Nafion® dispersions from DuPont de Nemours GmbH known from the prior art or of the fumion® dispersions from FuMa-Tech GmbH, with the dispersion obtained in process step ($\alpha$1). In this manner, dispersions are obtained in which the polymer b) which comprises $SO_3^-M^+$ groups (and is not fluorinated or perfluorinated) is present in the dispersion at least partly bonded as a complex (with the polythiophene a)) and the fluorinated or perfluorinated polymer c) having $SO_3^-M^+$ groups is present in the dispersion virtually completely in the free form not bonded as a complex. If appropriate, some of the polymer b) which comprises $SO_3^-M^+$ groups (and is not fluorinated or perfluorinated) can also be added only after conclusion of the polymerization reaction of the dispersion obtained in process step ($\alpha$1), so that in this embodiment of the process some of the polymer b) having $SO_3^-M^+$ groups is present in the dispersion bonded as a complex and a part (i.e. the part added only after conclusion of the polymerization reaction) is present in the dispersion not bonded as a complex.

If appropriate, in a further process step ($\alpha$3) the pH in the dispersions obtained in this manner can also be adjusted to a range of from 1 to 7, preferably to a range of from 5 to 7, by the addition of suitable bases, for example by the addition of alkali metal hydroxide solutions or ammonium hydroxide solutions.

The application of the dispersion in process step III) to the transparent substrate layer provided with the grid structure can be carried out, for example, by known processes, e.g. by spin coating, impregnation, pouring, dripping on, spraying, misting, knife coating, brushing or printing, for example ink-jet, screen, gravure, offset or tampon printing, in a wet film thickness of from 0.5 $\mu$m to 250 $\mu$m, preferably in a wet film thickness of from 2 $\mu$m to 50 $\mu$m. According to one possible embodiment of the process according to the invention, the dispersion is applied in a wet film thickness such that after the at least partial removal of the dispersing agent in process step IV) a conductive polymer layer is obtained, the thickness of which corresponds at least to the height of the bars. It is also conceivable to apply the dispersion in a wet film thickness such that after the at least partial removal of the dispersing agent in process step IV) a conductive polymer layer is obtained, the thickness of which is greater than the height of the bars and which thus covers the complete surface of the transparent substrate layer. To achieve the required thickness of the polymer layer, the dispersion can also be applied several times in succession, in each case followed by a drying step.

In process step IV) of the process according to the invention, the dispersing agent is then at least partially removed to obtain a transparent electrode. The at least partial removal of the dispersing agent is preferably carried out in this context by drying at a temperature in a range of from 20 °C to 200 °C, it possibly being advantageous to at least partially remove the supernatant dispersion from the substrate before the drying process, for example by spinning off.

A contribution towards achieving the abovementioned objects is also made by a transparent electrode which is obtainable by the process described above.

A contribution towards achieving the abovementioned objects is also made by a transparent electrode comprising

- a transparent substrate layer,

- a grid structure which is applied to the transparent substrate layer and comprises a plurality of bars of metal or at least comprising metallic particles, on the substrate layer,
  wherein the intermediate space between the bars of the grid structure is filled with a conductive polymer layer, at least comprising

  a) at least one polythiophene,

  b) at least one polymer having $SO_3^-M^+$ groups, and

  c) at least one fluorinated or perfluorinated polymer having $SO_3^-M^+$ groups, wherein $M^+$ represents $H^+$, $Li^+$, $Na^+$, $K^+$ or $NH_4^+$,

wherein this transparent electrode is obtainable, for example, by the process according to the invention for the production of a transparent electrode. Those substrates, grid structures or polymer which have already been described above as preferred substrates, grid structures and polymers in connection with the process according to the invention are preferred as the transparent substrate layer, as the grid structure comprising a plurality of bars of metal or at least comprising metallic particles, as the polythiophene a), as a polymer b) having $SO_3^-M^+$ groups and as the fluorinated or perfluorinated polymer c) having $SO_3^-M^+$ groups. The thickness of the conductive polymer layer in the transparent electrode according to the invention is preferably in a range of from 50 nm to 2 $\mu$m, particularly preferably in a range of from 200 nm to 1 $\mu$m.

A contribution towards achieving the abovementioned objects is also made by an electronic component comprising a transparent electrode obtainable by the process according to the invention or a transparent electrode according to the invention. The electronic component is preferably an OLED or an OPV element.

OLEDs comprising at least two electrodes, of which optionally at least one corresponds to the transparent electrode obtainable by the process according to the invention or to the transparent electrode according to the invention, and at least one emitter layer between the two electrodes are preferred. A preferred OLED according to the invention is built up from the following layers: transparent electrode obtainable by the process according to the invention or transparent electrode according to the invention/where appropriate hole transport layer/emitter layer/where appropriate electron injection layer/cathode.

Possible hole transport layers are, for example, layers comprising polyvinylcarbazole or derivatives thereof, polysilane or derivatives thereof, polysiloxane derivative with aromatic amine in the side or main chain, pyrazoline derivatives, arylamine derivatives, stilbene derivatives, triphenyldiamine derivatives, polyaniline or derivatives thereof, polythiophene and derivatives thereof, polyarylamine or derivatives thereof, polypyrrole or derivatives thereof, poly(p-phenylenevinylene) or derivatives thereof and poly(2,5-thienylenevinylene) or derivatives thereof. NPB (N,N'-bis(naphthalen-1-yl)-N,N'-bis(phenyl)benzidine) is particularly preferred as the hole transport layer.

Suitable materials for the emitter layer are conjugated polymers, such as polyphenylenevinylenes and/or polyfluorenes, for example the polyparaphenylenevinylene derivatives and polyfluorene derivatives described in WO-A-90/13148, or emitters from the class of low molecular weight emitters, also called *"small molecules"* in technical circles, such as aluminium complexes, such as, for example, tris(8-hydroxyquinolinato)aluminium ($Alq_3$), fluorescent dyestuffs, e.g. quinacridones, or phosphorescent emitters, such as, for example, $Ir(ppy)_3$. Further suitable materials for the emitter layer are described e.g. in DE-A-196 27 071. Tris(8-hydroxyquinolinato)aluminium ($Alq_3$) is particularly preferred according to the invention as the emitter layer.

Individual Ca layers or a stack structure of a Ca layer and another layer which is made of one or more materials chosen from metals of group IA and IIA of the periodic table, excluding Ca, which have an exit work of from 1.5 to 3.0 eV, and oxides, halides and carbonates thereof, are preferred for the electron injection layer. Examples of metals of group IA of the periodic table which have an exit work of from 1.5 to 3.0 eV and of oxides, halides and carbonates thereof are lithium, lithium fluoride, sodium oxide, lithium oxide and lithium carbonate. Examples of metals of group IIA of the periodic table, excluding Ca, which have an exit work of from 1.5 to 3.0 eV and of oxides, halides and carbonates thereof are strontium, magnesium oxide, magnesium fluoride, strontium fluoride, barium fluoride, strontium oxide and magnesium carbonate.

Suitable materials for the cathode layer are, in particular, transparent or translucent materials having a relatively low exit work (of preferably less than 4.0 eV). Examples of such materials are metals, such as, for example, lithium (Li), sodium (Na), potassium (K), rubidium (Rb), caesium (Cs), Be, magnesium (Mg), calcium (Ca), strontium (Sr), barium (Ba), aluminium (Al), scandium (Sc), vanadium (V), Zn, yttrium (Y), indium (In), cerium (Ce), samarium (Sm), Eu, Tb and ytterbium (Yb); alloys which comprise two or more of these metals; alloys which comprise one or more of these metals and one or more metals which are chosen from Au, Ag, Pt, Cu, manganese (Mn), titanium (Ti), cobalt (Co), nickel (Ni), tungsten (W) and tin (Sn); graphite or graphite intercalation compounds; and metal oxides, such as, for example, ITO and tin oxide. The use of aluminium as the cathode layer is particularly preferred.

The application of the further layers, in particular of the hole transport layer, of the emitter layer, of the electron injection layer and of the cathode layer, can be carried out in the manner known to the person skilled in the art, preferably by vapour deposition, such as is described, for example, in WO-A-2009/0170244.

In addition to the layers mentioned above, an OLED according to the invention can comprise further functional layers. One layer can also assume several tasks. Thus, for example, the transparent electrode obtainable by the process according to the invention or the transparent electrode according to the invention assumes the function of the ITO layer and of the hole injection layer in a conventional OLED described above. Furthermore, for example, the emitter materials mentioned above can be employed in combination with a hole-transporting intermediate layer between the transparent electrode obtainable by the process according to the invention or the transparent electrode according to the invention and the emitter layer (cf. e.g. US 4,539,507 and US 5,150,006).

With respect to the details of the production of an OLED described above, reference is made to the statements in DE-A-10 2004 010 811.

Due to the particularly high conductivity and the high transmission of the transparent electrode obtainable by the process according to the invention or the transparent electrode according to the invention, a use of ITO layers can be dispensed with, so that according to a particularly preferred embodiment of the OLEDs according to the invention (and also of the OPV elements according to the invention), these electronic components comprise no ITO layer.

A contribution towards achieving the abovementioned objects is also made by a dispersion comprising

a) at least one polythiophene,

b) at least one polymer having $SO_3^-M^+$ groups,

c) at least one fluorinated or perfluorinated polymer having $SO_3^-M^+$ groups, and

d) at least one dispersing agent,

wherein $M^+$ represents $H^+$, $Li^+$, $Na^+$, $K^+$ or $NH_4^+$ and wherein the dispersion is characterized by an FOM value (FOM = "figure of merit") of at most 100 Ω/sq, particularly preferably of at most 50 Ω/sq and most preferably of at most 25 Ω/sq. With respect to the preferred embodiments of the dispersion according to the invention, reference is made to the detailed statements regarding the dispersion employed in process step III) of the process according to the invention.

A contribution towards achieving the abovementioned objects is also made by a lighting means comprising a transparent vessel, at least enclosing an OLED according to the invention. For the use in this text, a transparent vessel is a vessel which has a transmission coefficient, with respect to the electromagnetic radiation which the OLED enclosed in the transparent vessel emits, of at least 0.5, preferably at least 0.6, more preferably at least 0.7, still more preferably at least 0.8, still more preferably at least 0.9, still more preferably at least 0.95. The transmission coefficient may be defined as the ratio of the intensity of the electromagnetic radiation radiated by an OLED enclosed in a vessel on to the internal wall of the vessel to an intensity of the electromagnetic radiation radiated out by the OLED in the vessel outside of the vessel.

In a preferred embodiment of the lighting means according to the invention, the transparent vessel encloses an inert gas. For the use in this text, an inert gas is a gas which reduces the luminous density of an OLED which is in chemical contact with the gas by a maximum of 10 %, preferably by a maximum of 5 %, more preferably by a maximum of 1 %, still more preferably by a maximum of 0.1 % over a period of at least 2 weeks by chemical reactions of the gas with the OLED. The inert gas is preferably at least one gas chosen from the group of $N_2$, He, Ne, Ar, Kr, Xe, $CO_2$ or a combination of at least two of these.

In a further preferred embodiment of the lighting means according to the invention, the transparent vessel is evacuated. For the use in this text, a vessel is evacuated if a gas pressure which corresponds to a maximum of 50 %, preferably a maximum of 25 %, more preferably a maximum of 5 %, still more preferably a maximum of 1 % of the gas pressure outside the vessel prevails in the vessel.

In a further preferred embodiment of the lighting means according to the invention, the transparent vessel is hermetically sealed. For the use in this text, a vessel is hermetically sealed if the permeation of water vapour into the transparent vessel is less than $10^{-6}$ g/($m^2$*d), particularly preferably less than $10^{-8}$- g/($m^2$*d), where $m^2$ takes into account the total outer surface of the vessel.

In a further preferred embodiment of the lighting means according to the invention, the transparent vessel is made of a glass, a plastic or a transparent material which appears to be suitable for this to the person skilled in the art.

In a further preferred embodiment of the lighting means according to the invention, the OLED according to the invention is flexible such that it can be rolled up in order to fit into the transparent vessel. For this, the transparent substrate is preferably a film, more preferably a film of plastic.

In a further preferred embodiment of the lighting means according to the invention, the transparent vessel and therefore the lighting means has the smallest possible dimensions, so that the largest possible number of lighting means can be used on one area. The total luminous density per area occupied by lighting means can thus be increased.

In a further preferred embodiment of the lighting means according to the invention, several OLEDs are enclosed in the transparent vessel in order to achieve the highest possible luminous density of the lighting means.

In a further preferred embodiment of the lighting means according to the invention, the lighting means is used in an arrangement which increases the luminous density in a particular solid angle element. Such an arrangement can comprise a reflecting layer on the internal wall of the transparent vessel. A metallic layer is suitable in particular as the reflecting layer. The optical system can also be a refractive optical system. A preferred refractive optical system is a lens.

In a further preferred embodiment of the lighting means according to the invention, the lighting means is used in an arrangement which manipulates the electromagnetic spectrum of the electromagnetic radiation emitted by the OLED. The manipulation of the electromagnetic spectrum of the electromagnetic radiation emitted by the OLED can be a selective absorption of wavelength ranges, a change in the emission direction of wavelength ranges or a shift in the wavelength of ranges of the electromagnetic spectrum. In this context the arrangement preferably comprises at least one element from the group of an absorption mask, an optical prism, a lens, a light conductor, a fluorescent substance or a combination of these.

A contribution towards achieving the abovementioned objects is also made by a process for the production of a lighting means, wherein the production process comprises at least the process steps of provision of an OLED according to the invention and introduction of the OLED according to the invention into a transparent vessel.

The invention is now explained in more detail with the aid of test methods and non-limiting figures and examples.

Figure 1 shows a first embodiment of a transparent electrode obtainable by the process according to the invention or of an inventive transparent electrode in cross-section. This comprises a transparent substrate layer 1, on to which bars 2 of metal or at least comprising metallic particles are applied. The intermediate space between adjacent bars 2 is filled with a layer 3 comprising at least one polythiophene, at least one polymer having $SO_3^-M^+$ groups and at least one fluorinated or perfluorinated polymer having $SO_3^-M^+$ groups. In this first embodiment, the thickness of the layer 3 approximately corresponds to the height of the bars 2.

Figure 2 shows a second embodiment of a transparent electrode obtainable by the process according to the invention or of an inventive transparent electrode in cross-section. In contrast to the first embodiment in Figure 1, the thickness of the layer 3 here is greater than the height of the bars 2, so that the layer 3 covers the complete surface of the transparent substrate layer 1.

Figure 3 shows an OLED construction 8 according to the invention in cross-section, which comprises the transparent electrode from Figure 2 as the base electrode. A hole transport layer 4, which can be, for example, a layer of NPB (N,N'-bis(naphthalen-1-yl)-N,N'-bis(phenyl)benzidine) is applied to this base electrode, followed by an emitter layer 5, which can be, for example, a layer of Alq3 (tris-(8-hydroxyquinoline)aluminium). The emitter layer 5 can be followed by an electron injection layer 6 (e.g. an LiF layer). A cathode layer 7 (e.g. aluminium) is applied to the outside.

The lighting means shown in Figure 4 comprises an OLED construction 8 according to Figure 3, the OLED construction 8 being encapsulated. The OLED construction 8 is in a transparent glass cylinder having a base plate 9. The glass cylinder having a base plate 9 has a diameter of 40 mm and is open at the top. An opening at the top of the glass cylinder having a base plate 9 is closed by a transparent circular glass plate 10 having a diameter of 45 mm and a thickness of 1 mm and sealed with a 2-component epoxy adhesive (type: UHU-Plus 300). The glass cylinder having a base plate 9 which is closed in this way contains an inert gas 11. On one side of the glass plate 10 which faces the glass cylinder having a base plate 9, two electrodes 12 electrically insulated from one another are vapour-deposited such that they connect an inner space of the glass cylinder having a base plate 9 to an outer space of the glass cylinder having a base plate 9 in an electrically conductive manner. The electrodes 12 comprise a 200 nm thick Ag layer. The electrodes 12 are each connected to an electrically insulated Cu wire 13. The electrical connection between the Cu wire 13 and electrode 12 is in each case established by one drop of epoxy conductive adhesive 14 (type: CW2400, ITW Chemtronics). The OLED construction 8 according to Figure 3 comprises a transparent substrate layer 1, OLED layers 15, bars of metal or at least comprising metallic particles 2 and an electrically conductive cross-bar 16, the electrically conductive cross-bar 16 connecting all the bars of metal or at least comprising metallic particles 2 perpendicularly and centrally transversely and to one another. In this context the OLED construction 8 is flexible such that in the rolled-up state it can be enclosed in the glass cylinder having a base plate 9. The OLED layers 15 are applied to an area of 40 mm x 40 mm on the transparent substrate layer 1 and comprise a layer comprising components a), b) and c) 3, a hole transport layer 4, an emitter layer 5, an electron injection layer 6 and a cathode layer 7 according to Figure 3. One of the two Cu wires 13 is connected to the cathode layer 7 according to Figure 3 in an electrically conductive manner. A further Cu wire 13 is connected electrically to the electrically conductive cross-bar 16. The OLED construction 8 is rolled up parallel to the longitudinal axis of the glass cylinder having a base plate 9 such that the OLED construction 8 fits completely into the glass cylinder having a base plate 9, the substrate layer 1 facing outwards to the wall of the glass cylinder having a base plate 9 and the OLED layers 15 facing inwards to the longitudinal axis of the glass cylinder having a base plate 9. On the base of the glass cylinder 9 having a base plate are 2 Dryflex dryers 17 (type: DFX/SS-30-A/F/10X18X0.14, SAES Getters GmbH).

Test methods

Determination of the FOM value

For characterization of the surface resistance and the light absorption of a transparent, conductive polymer layer, the polymer solution is distributed on a glass substrate 25 mm x 25 mm in size with the aid of a lacquer whirler coater and then dried on a hot plate.

The absorption of the layer is recorded with a 2-channel spectrometer (PerkinElmer Lambda 900). The spectrometer is equipped with a photometer sphere. The coated substrate for measurement is fixed in this such that the measurement beam penetrates centrally through the substrate at an angle of 8°. The intensity of the transmitted and of the reflected light of the measurement beam are thus recorded together. The difference between the intensity measured with and without the layer corresponds to the absorption, corresponding to $A = 1 - (T + R)$. The intensity spectrum is recorded in the range from 320 nm to 780 nm. In accordance with ASTM E308, the standard spectral value Y for light type D65 and the 10° observer is calculated from the intensity spectrum.

The surface resistance of the layer is determined by first vapour-depositing two silver electrodes, arranged parallel, on to the layer with the aid of a shadow mask. The electrodes have a length of 20 mm and are 10 mm apart. The region between the electrodes is electrically insulated by scratching off the layer parallel to the electrode edges. The resistance between the two Ag electrodes is determined using an ohmmeter. The surface resistance (SR) then corresponds to twice the value of the resistance measured.

From the standard colour value Y of the coated substrate, $Y_0$ of the non-coated substrate and from the surface resistance SR, the "figure of merit" value (FOM value, stated in [Ω/sq]) is calculated as follows:

$$\mathrm{FOM} = \ln(Y_0/Y) \times \mathrm{SR}.$$

This value corresponds to the absorption constant, averaged over the visible spectral range, divided by the conductivity of the layer (see R.G. Gordon, MRS Bulletin/August 2000, page 52).

Viscosity measurement

The viscosity is determined with the aid of a Haake RV 1 rheometer connected to a cryostat. For this, a DG 43 measuring cup with double gap and a DG 43 rotor, both from Haake, are used. 12 g of the aqueous solution are weighed into the measuring cup. The temperature is regulated at 20 °C by means of the cryostat. For temperature control of the dispersion, temperature control is first carried out for 240 seconds at a shear rate of 50 $s^{-1}$. The shear rate is then increased to 100 $s^{-1}$. The system is left at this shear rate for 30 seconds. 30 viscosity measurements are then carried out at a shear rate of 100 $s^{-1}$ over a further 30 seconds (1 measurement value/second). The mean of these 30 measurement values is the viscosity value of the dispersion.

Examples

The examples are based in part on commercial PEDOT/PSS dispersions from Heraeus Precious Metals GmbH & Co KG. Since these are published and are freely available on the market, synthesis instructions for the preparation of the PEDOT/PSS dispersions are omitted.

Comparison Example 1: Preparation of a formulation of highly conductive PEDOT/PSS

84.2 g of Clevios PH 510 (PEDOT/PSS in water, 2.2 % strength, Heraeus Precious Metals, Germany) and 45.4 g of polystyrenesulphonic acid (PSS, 5.99 % strength, Mw = 350,000 g/mol; Agfa Gevaert, Belgium) are mixed. The mixture is then homogenized 5 times under 600 bar. 5 g of DMSO (Sigma-Aldrich Chemie GmbH, Germany) are also added to in each case 95 g of this mixture and the mixture is stirred for 15 min.

Analysis:

| | |
|---|---|
| Solids content: | 3.4 % |
| Viscosity: | 50 mPas [100 $s^{-1}$; 20 °C] |
| Conductivity: | 93 S/cm |
| FOM value: | 24.4 Ω/sq |

Example 1: Preparation of a formulation of highly conductive PEDOT/PSS and a perfluorinated polymeric sulphonic acid (according to the invention)

315 g of Clevios PH 510 (PEDOT/PSS in water; 1.95 % strength; Heraeus Precious Metals, Germany) are mixed with 179 g of fumion® FLA-805 (sulphonated fluorine polymer; 4.91 % strength in water, FuMA-Tech GmbH, Germany). The mixture is then homogenized 5 times under 600 bar. 5 g of DMSO (Sigma-Aldrich Chemie GmbH, Germany) are also added to in each case 95 g of this mixture and the mixture is stirred for 15 min.

Analysis:

| | |
|---|---|
| Solids content: | 2.69 % |
| Viscosity: | 7 mPas [100 $s^{-1}$; 20 °C] |
| Conductivity: | 220 S/cm |
| FOM value: | 14.5 Ω/sq |

Example 2: Preparation of a formulation of highly conductive PEDOT/PSS and a perfluorinated polymeric sulphonic acid (according to the invention)

315 g of Clevios PH 510 (PEDOT/PSS in water; 1.95 % strength; Heraeus Precious Metals, Germany) are mixed with 102 g of polystyrenesulphonic acid (5.99 % strength, Mw = 350,000 g/mol; Agfa-Gevaert, Belgium) and 53.7 g of fumion® FLA-805 (sulphonated fluorine polymer; 4.91 % strength in water; FuMA-Tech GmbH, Germany). The mixture is then homogenized 5 times under 600 bar. 5 g of DMSO (Sigma-Aldrich Chemie GmbH, Germany) are also added to in each case 95 g of this mixture and the mixture is stirred for 15 min.

Analysis:

| | |
|---|---|
| Solids content: | 2.89 % |
| Viscosity: | 16 mPas [100 $s^{-1}$; 20 °C] |
| Conductivity: | 156 S/cm |
| FOM value: | 20.2 Ω/sq |

Example 3: Preparation of a formulation of highly conductive PEDOT/PSS and a perfluorinated polymeric sulphonic acid (according to the invention)

314 g of Clevios PH 510 (PEDOT/PSS in water; 1.95 % strength; Heraeus Precious Metals, Germany) are mixed with 179 g of fumion® FLA-805 (FuMA-Tech GmbH, Germany). The mixture is then homogenized 5 times under 600 bar. 5 g of DMSO (Sigma-Aldrich Chemie GmbH, Germany) are also added to in each case 95 g of this mixture and the mixture is stirred for 15 min. The mixture is then adjusted to a pH of 6 with 25 % strength ammonium hydroxide solution (Sigma-Aldrich Chemie GmbH, D-89555 Steinheim).

Analysis:

| | |
|---|---|
| Solids content: | 2.4 % |
| Viscosity: | 6 mPas [100 $s^{-1}$; 20 °C] |
| Conductivity: | 121 S/cm |
| FOM value: | 28.3 Ω/sq |

Example 4: Preparation of a formulation of highly conductive PEDOT/PSS and a perfluorinated polymeric sulphonic acid (according to the invention)

314 g of Clevios PH 510 (PEDOT/PSS in water; 1.95 % strength; Heraeus Precious Metals, Germany) are mixed with 179 g of fumion® FLA-805 (FuMA-Tech GmbH, Germany). The mixture is then homogenized 5 times under 600 bar. 5 g of DMSO (Sigma-Aldrich Chemie GmbH, Germany) are also added to in each case 95 g of this mixture and the mixture is stirred for 15 min. The mixture is then adjusted to a pH of 6 with 25 % strength ammonium hydroxide solution (Sigma-Aldrich Chemie GmbH, D-89555 Steinheim). 0.1 g of Silquest® Wetlink 78 (Momentive, Germany) were furthermore added to in each case 100 g of dispersion as a crosslinking agent.

Analysis:

| | |
|---|---|
| Solids content: | 2.4 % |
| Viscosity: | 6 mPas [100 $s^{-1}$; 20 °C] |
| Conductivity: | 213 S/cm |
| FOM value: | 17.4 Ω/sq |

Table 1 Compositions and pH values of the mixtures prepared in Comparison Example 1 and Examples 1 to 4

| | PEDOT content | PSS content | Fluorine polymer content | pH | Crosslinking agent [%] |
|---|---|---|---|---|---|
| Comp. 1 | 1 | 7.5 | 0 | <2 | 0 |
| Comp. 2 | 1 | 7.5 | 0 | 6 | 0.1 |
| Example 1 | 1 | 2.5 | 5 | <2 | 0 |
| Example 2 | 1 | 6 | 1.5 | <2 | 0 |
| Example 3 | 1 | 2.5 | 5 | 6 | 0 |
| Example 4 | 1 | 2.5 | 5 | 6 | 0.1 |

Example 5: Production of OLEDs without an ITO layer

Construction and characterization of ITO-free OLEDs comprising dispersion according to the invention

A continuous structure of metal bars is vapour-deposited on to a glass substrate 50 mm x 50 mm in size with the aid of a shadow mask. This structure comprises 10 lines of width 1 mm and length 45 mm, which are arranged parallel to one another at a distance apart of 3.5 mm. A 3 mm wide line, which connects all the transverse lines to one another, crosses centrally perpendicularly thereto. The metal bars comprising the layer sequence: 10 nm chromium, 200 nm silver and 10 nm chromium are vapour-deposited in a vapour deposition unit (Leybold, Univex 350).

A dispersion according to the invention from Example 4 is applied on to the substrate vapour-deposited with metal bars. This dispersion is deposited with the aid of a lacquer whirler coater (Carl Süss, RC8). For this, the substrate is wetted completely with the solution and the solution is removed by spinning at 500 rpm at an acceleration of 200 rpm/s for 30 sec with the lid open. The layer is then dried on a hot-plate at 130 °C for 15 min. The layer thickness between the metal bars is 200 nm, measured with a stylus profilometer (Dektak 150, Veeco).

In the next step the substrate is transferred into the vapour deposition unit (Univex 350, Leybold) again. Under a pressure of $10^{-3}$ Pa, two organic molecular layers are vapour-deposited successively from two separate vaporizers: first the hole transport layer of NPB (N,N'-bis(naphthalen-1-yl)-N,N'-bis(phenyl)benzidine) in a thickness of 60 nm and then the emitter layer of Alq3 (tris-(8-hydroxyquinoline)aluminium) in a thickness of 50 nm. The vapour deposition rate is in each case 1 Å/sec.

The layer system is then transferred into a vapour deposition unit (Edwards), which is in a glove box filled with an $N_2$ atmosphere, and vapour-deposited with individual cathodes. For this, a shadow mask with 8 perforations of in each case 2.0 mm diameter is used. The perforated mask is positioned such that the holes are between the parallel metal bars without touching these. A 0.5 nm thick LiF layer and then a 200 nm thick Al layer were vapour-deposited successively from two vapour deposition boats under a pressure of $p = 10^{-3}$ Pa. The vapour deposition rates are 1 Å/s for LiF and 10 Å/s for Al. The area of the individual OLEDs is 3.14 $mm^2$.

The OLED test structures remain in the glove box filled with an $N_2$ atmosphere and are characterized there. For this, the central metal bar is connected to the positive pole and the vapour-deposited metal contact is connected via a sprung gold wire to the negative pole of a current/voltage source. The OLED here is above an Si photodiode for recording of the electroluminescence (EL). By increasing the voltage stepwise in the range from -8 V to +8 V, current/voltage characteristic lines are recorded, with simultaneous detection of the EL intensity. Operating life measurements are then performed wherein a regulated current of a constant 1.507 mA flows through the OLED and simultaneously the increase in the voltage applied and the decrease in the EL intensity are recorded.

Comparative Example 2

The procedure is as in Example 5, except that instead of the dispersion according to the invention the dispersion from Comparison Example 1 is used, this first being adjusted to a pH of 6 with 25 % strength ammonium hydroxide

solution (Sigma-Aldrich Chemie GmbH, D-89555 Steinheim) and 0.1 g of Silquest® Wetlink 78 (Momentive, Germany) furthermore being added to 100 g of this dispersion as a crosslinking agent. Analogously to Example 5, a 200 nm thick layer is deposited on the substrate by spinning off the solution at 1,600 rpm under otherwise identical conditions and then drying.

Table 2 shows characteristic lines and operating lives for the OLED construction ITO/HIL (Example 5, Comparison Example 2)//NPB//Alq3//LiF//Al

| | Characteristic lines at U = 5 V | | | Operating life (@ I = 48 mA/cm$^2$) | | | |
|---|---|---|---|---|---|---|---|
| | I [A/cm$^2$] | L [cd/m$^2$] | Eff. [cd/A] | U (t=0) [V] | U(t=60h) -U (t=0) [V] | L (t=0) [cd/m$^2$] | T (50% $L_0$) [h] |
| Ex. 5 | 0.0457 | 882 | 1.93 | 5.02 | 5.58 | 1,020 | 180 |
| Comp. 2 | 0.0200 | 410 | 2.05 | 5.47 | 7.49 | 1,080 | 5 |

It is thus shown that the dispersion according to the invention is suitable as a transparent, conductive electrode for replacing ITO, and that the addition of a fluorine polymer also leads to a significant improvement in the OLED properties in the absence of an ITO layer. The EL intensity at U = 5 V is thus higher by more than a factor of 2 and the operating life is likewise improved significantly.

Example 6: Production of an OLED lighting means on ITO-free PET film having metallic busbars and a coating of the substance according to the invention and subsequent encapsulation of this arrangement

The procedure is as in Example 5 with the following differences: 1) A PET film (Melinex 505, DuPont Teijin, 175 μm thick) 50 x 50 mm$^2$ in size serves as the substrate instead of the glass substrate. 2) A different shadow mask is used in the cathode vapour deposition. The shadow mask covers the substrate completely and has a square opening of 40 x 40 mm$^2$ in the centre. After the vapour deposition step for the cathode, in which a 0.5 nm thick LiF layer and then a 200 nm thick Al layer are vapour-deposited successively under a pressure of p = $10^{-3}$ Pa, the OLED lamp is subjected to function testing in the glove box filled with an $N_2$ atmosphere. For this, the plus pole of a 4.5 V battery is connected to the central metal bar and the minus pole is connected to the cathode via a thin flexible gold wire. The arrangement lights homogeneously over the entire cathode area.

A snap-cover glass of 40 mm diameter serves for encapsulation of the OLED lighting means. The opening is removed with the aid of a diamond saw and the cut is smoothed on a polishing disc. A glass cylinder of approx. 80 mm height which is closed at the bottom and open at the top is thus formed. The snap-cover glass decapitated in this way is transferred into the glove box and dried thoroughly there on a hot-plate at 150 °C for several hours. A circular glass disc 1 mm thick having a diameter of approx. 45 mm is vapour-deposited with 200 nm Ag on one side, a 5 mm wide band clamp lying centrally on the substrate as a shadow mask separating the vapour-deposited Ag layer into two regions electrically insulated from one another. These two electrodes are now connected to the cathode and anode of the OLED lighting means using wires. For this, the thin, insulated Cu wires are each fixed to the corresponding electrodes with a small drop of an epoxy conductive adhesive (CW2400, ITW Chemtronics, Georgia). After thorough drying of the epoxy conductive adhesive, the OLED lighting means is rolled up and inserted into the snap-cover glass. The cathode is orientated inwards here. Two Dryflex dryers (DFX/SS-30-A/F/10X18X0.14, SAES Getters GmbH, D) are stuck on to the base of the snap-cover glass beforehand. The cut edge is coated completely with a 2-component epoxy adhesive (UHU-Plus 300) and the glass cover, with the electrodes to the adhesive, is firmly pressed on. The contact wires are now completely in the snap-cover glass without taking up space in the gluing region. After thorough drying of the epoxy adhesive under pressure, the OLED lighting means encapsulated in this way can be locked out of the glove box.

By connecting the two vapour-deposited Ag electrodes of the somewhat projecting glass cover to the plus and minus pole of the battery, the OLED lighting means can now also be operated in ambient air. The luminous density at an applied voltage of 4.5 volt is 30 cd/m$^2$. No decrease in the luminous density is detectable over an observation period of 2 weeks. OLED lighting means which are not hermetically encapsulated would already be unusable after storage in air for a few minutes.

List of Reference Symbols

1 Transparent substrate layer

2 Bars of metal or at least comprising metallic particles
3 Layer comprising components a), b) and c)
4 Hole transport layer
5 Emitter layer
6 Electron injection layer
7 Cathode layer
8 OLED construction
9 Glass cylinder having a base plate
10 Circular glass plate
11 Inert gas
12 Electrodes
13 Electrically insulated Cu wires
14 Electrically conductive epoxy adhesive
15 OLED layers
16 Electrically conductive cross-bar
17 Dryflex dryer

## Claims

**1.** Use of a dispersion comprising

a) at least one polythiophene, wherein the polythiophene is poly(3,4-ethylenedioxythiophene),
b) at least one polymer having $SO_3^-M^+$ groups, wherein the polymer having $SO_3^-$ $M^+$ groups is a polystyrenesulphonic acid,
c) at least one fluorinated or perfluorinated polymer having $SO_3^-M^+$ groups, wherein the fluorinated or perfluorinated polymer having $SO_3^-M^+$ groups is a copolymer of a perfluorinated sulphonic acid and tetrafluoroethylene, and
d) at least one dispersing agent,

wherein $M^+$ represents $H^+$, $Li^+$, $Na^+$, $K^+$ or $NH_4^+$ and
wherein the dispersion is **characterized by** an FOM value of at most 100 Ω/sq, wherein the dispersion additionally comprises additives which increase the conductivity selected from the group consisting of polyalkylene glycols, polyglycerols, polyols, sulphoxides, carboxylic acid amides, ionic liquids and sugars,
for the deposition of a transparent conductive layer which in an OLED or an OPV element serves at the same time as a hole injection layer and as a base electrode.

**2.** Use according to claim 1, wherein the dispersion is **characterized by** an FOM value of at most 50 Ω/sq.

**3.** Use according to claim 2, wherein the dispersion is **characterized by** an FOM value of at most 25 Ω/sq.

## Patentansprüche

**1.** Verwendung einer Dispersion, umfassend

a) mindestens ein Polythiophen, worin das Polythiophen Poly(3,4-ethylendioxythiophen) ist,
b) mindestens ein Polymer mit $SO_3^-M^+$-Gruppen, worin das Polymer mit $SO_3^-M^+$-Gruppen eine Polystyrolsulfonsäure ist,
c) mindestens ein fluoriertes oder perfluoriertes Polymer mit $SO_3^-M^+$-Gruppen, worin das fluorierte oder perfluorierte Polymer mit $SO_3^-M^+$-Gruppen ein Copolymer aus einer perfluorierten Sulfonsäure und Tetrafluorethylen ist, und
d) mindestens ein Dispersionsmittel,

wobei $M^+$ $H^+$, $Li^+$, $Na^+$, $K^+$ oder $NH_4^+$ darstellt und
wobei die Dispersion durch einen FOM-Wert von höchstens 100 Ω/sq gekennzeichnet ist,
wobei die Dispersion zusätzlich Additive umfasst, die die Leitfähigkeit erhöhen, ausgewählt aus der Gruppe bestehend aus Polyalkylenglykolen, Polyglycerinen, Polyolen, Sulfoxiden, Carbonsäureamiden, ionischen Flüssigkeiten

und Zuckern,
zum Abscheiden einer transparenten leitfähigen Schicht, die in einer OLED oder einem OPV-Element gleichzeitig als Lochinjektionsschicht und als Basiselektrode dient.

**2.** Verwendung nach Anspruch 1, wobei die Dispersion durch einen FOM-Wert von höchstens 50 Ω/sq gekennzeichnet ist.

**3.** Verwendung nach Anspruch 2, wobei die Dispersion durch einen FOM-Wert von höchstens 25 Ω/sq gekennzeichnet ist.

**Revendications**

**1.** Utilisation d'une dispersion comprenant

a) au moins un polythiophène, dans lequel le polythiophène est le poly(3,4-éthylènedioxythiophène),
b) au moins un polymère ayant des groupes $SO_3^-M^+$, dans lequel le polymère ayant des groupes $SO_3^-M^+$ est un acide polystyrène sulfonique,
c) au moins un polymère fluoré ou perfluoré ayant des groupes $SO_3^-M^+$, dans lequel le polymère fluoré ou perfluoré ayant des groupes $SO_3^-M^+$ est un copolymère d'un acide sulfonique perfluoré et de tétrafluoroéthylène, et
d) au moins un agent dispersant,

dans laquelle $M^+$ représente $H^+$, $Li^+$, $Na^+$, $K^+$ ou $NH_4^+$ et
dans laquelle la dispersion est **caractérisée par** une valeur FOM d'au plus 100 Ω/sq, dans laquelle la dispersion comprend en outre des additifs qui augmentent la conductivité choisis dans le groupe constitué des polyalkylèneglycols, polyglycérols, polyols, polyols, sulfoxydes, amides d'acides carboxyliques, liquides ioniques et sucres, pour le dépôt d'une couche conductrice transparente qui, dans un élément OLED ou OPV, sert à la fois de couche d'injection de trous et d'électrode de base.

**2.** Utilisation selon la revendication 1, dans laquelle la dispersion est **caractérisée par** une valeur FOM d'au plus 50 Ω/sq.

**3.** Utilisation selon la revendication 2, dans laquelle la dispersion est **caractérisée par** une valeur FOM d'au plus 25 Ω/sq.

Fig. 1

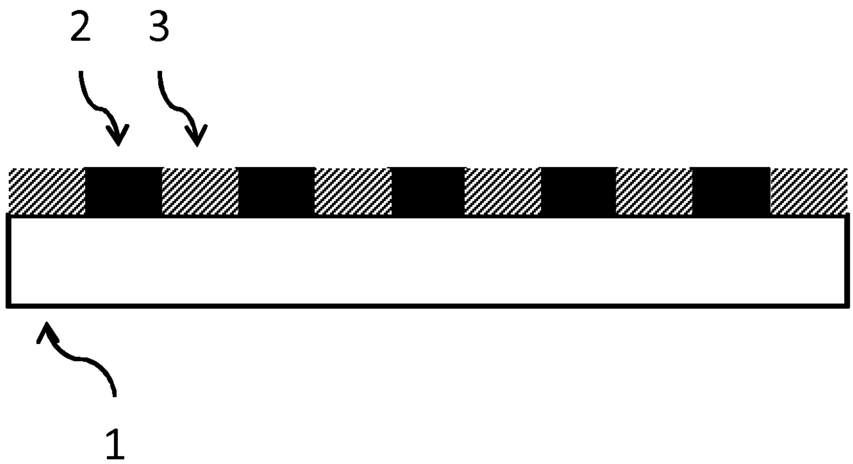


1/4

Fig. 2

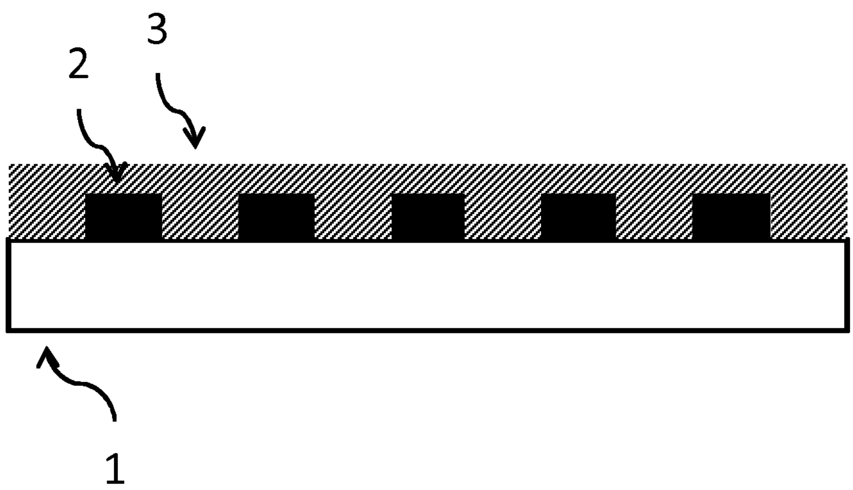


2/4

Fig. 3

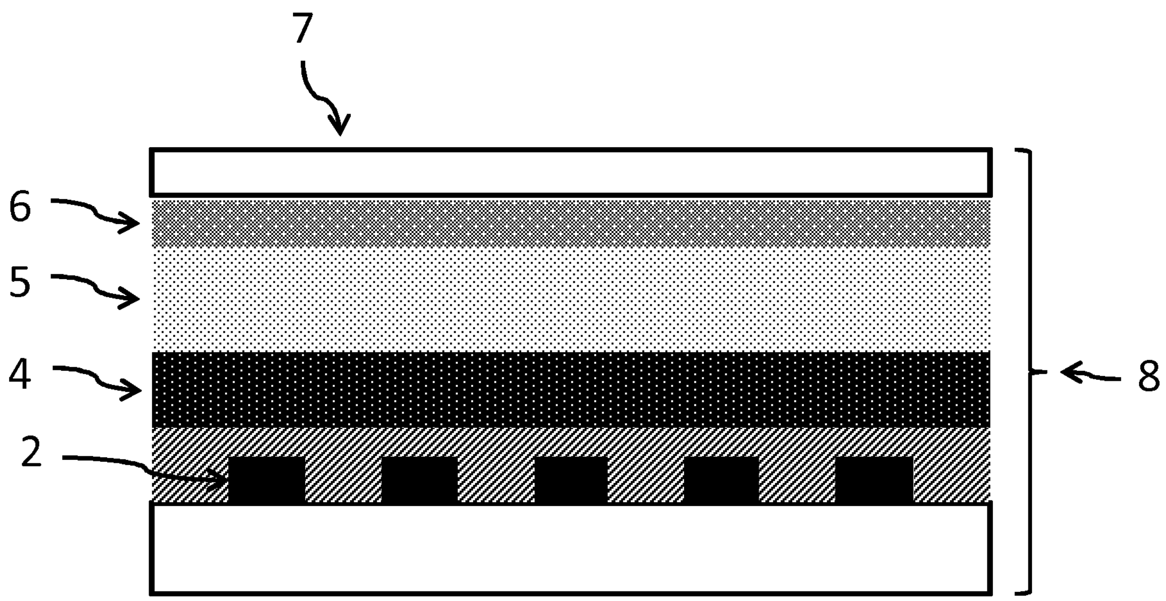


3/4

Fig. 4

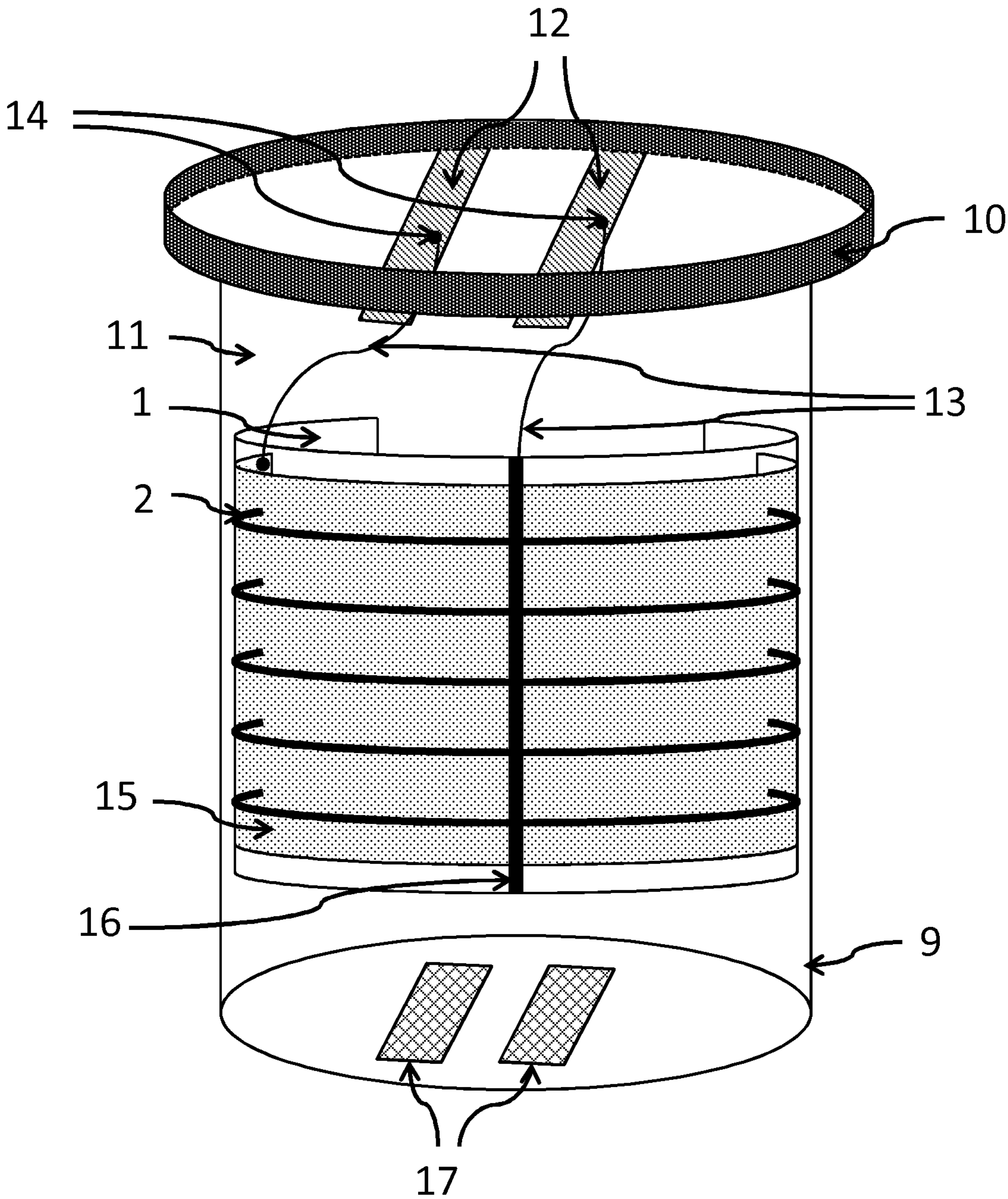


4/4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- DE 102004010811 A
- EP 991303 A
- DE 102007041722 A
- WO 9013148 A
- DE 19627071 A
- WO 20090170244 A
- US 4539507 A
- US 5150006 A


### Non-patent literature cited in the description


- **MARKUS GLATTHAAR.** Zur Funktionsweise organischer Solarzellen auf der Basis interpenetrierender Donator/Akzeptor-Netzwerke. University of Freiburg, 2007
- Makromolekulare Stoffe. *Houben Weyl, Methoden der organischen Chemie,* 1987, vol. E 20, 1141
- **ELSCHNER et al.** PEDOT · Principles and Applications of an Intrinsically Conductive Polymer. CRC Press, 2011
- *Colloid Polym. Sci.,* 1989, vol. 267, 1113-1116
- Handbook of Conducting Polymers. Marcel Dekker, 1986, vol. 1, 46-57
- **R.G. GORDON.** *MRS Bulletin,* August 2000, 52